# EUROPEAN PATENT SPECIFICATION

(11) **EP 4 105 281 B1**
(45) Date of publication and mention of the grant of the patent: **29.01.2025**
(21) Application number: 21753506.1
(22) Date of filing: 10.02.2021
(51) Int. Cl.: C08L 23/12, C08J 5/18, B32B 15/085, H01G 4/32, H01G 4/012, H01G 4/015, H01G 4/18

(54) **POLYPROPYLENE FILM, POLYPROPYLENE FILM INTEGRATED WITH METAL LAYER, AND FILM CAPACITOR**
POLYPROPYLENFOLIE, MIT METALLSCHICHT INTEGRIERTE POLYPROPYLENFOLIE UND FOLIENKONDENSATOR
FILM DE POLYPROPYLÈNE, FILM DE POLYPROPYLÈNE INTÉGRÉ AVEC UNE COUCHE MÉTALLIQUE, ET CONDENSATEUR À FILM

(30) Priority: 12.02.2020 JP 2020021942
(43) Date of publication of application: 21.12.2022
(73) Proprietor: Oji Holdings Corporation, Chuo-ku Tokyo 104-0061 (JP)
(72) Inventor: ISHIDA, Tatsuji, Tokyo 104-0061 (JP); TOMINAGA, Takeshi, Tokyo 104-0061 (JP); ISHIWATA, Tadakazu, Tokyo 104-0061 (JP)
(74) Representative: Müller-Boré & Partner Patentanwälte PartG mbB
(86) International application number: PCT/JP2021/004874
(87) International publication number: WO 2021/162021

(56) References cited:
- EP-A1- 3 431 530
- WO-A1-2009/060944
- WO-A1-2013/105552
- WO-A1-2019/022004
- JP-A- 2017 101 229
- JP-A- 2019 167 512
- US-A1- 2019 284 354

## Description

### Technical Field

The present invention relates to a polypropylene film, a metal layer-integrated polypropylene film, and a film capacitor.

### Background Art

Polypropylene films can be used as capacitor derivatives. For example, they can be used as capacitor derivatives in inverters that constitute power control units of hybrid cars, electric cars, or the like.

### Citation List

### Patent Literature

PTL 1: WO2018/056404

### Summary of Invention

### Technical Problem

Capacitors using polypropylene films as capacitor derivatives desirably have excellent heat resistance at a high temperature of about 120°C (100°C to 120°C) while being compact, lightweight, and high-capacity, from the viewpoint of the above-mentioned usage environments (e.g., an environment where the temperature rises in the engine room, and self-heating of capacitors). Specifically, it is required, for example, that the decrease in the capacitance of the capacitor is suppressed even after use for a long period of time at the above high temperature (excellent lifetime performance), and that heat tightening (deformation) of the capacitor is suppressed in repeated use between the above high temperature, assuming inside the engine room, and a low temperature (excellent heat shock resistance).

Further, polypropylene films for producing capacitors mentioned above are required to have, for example, excellent dielectric breakdown strength when a direct voltage is applied and excellent dielectric breakdown strength when an alternating voltage is applied at the above high temperature, even when the film thickness is as thin as less than 20 µm, and to have suppressed heat shrinkage in the machine direction (MD) at temperatures up to about 150°C exceeding the above high temperature (excellent heat shrinkage resistance).

However, the polypropylene film and the capacitor using the same disclosed in PTL 1 mentioned above do not comprehensively satisfy the excellent lifetime performance and excellent heat shock resistance as capacitor performance, as well as the excellent dielectric breakdown strength and excellent heat shrinkage resistance as film performance. There is room for further improvement.

The present invention has been made in consideration of the above problems, and an object thereof is to provide a polypropylene film having excellent dielectric breakdown strength at high temperatures and heat shrinkage resistance, and a film capacitor using the polypropylene film and having excellent lifetime performance at high temperatures and excellent heat shock resistance, as well as their production methods.

Another object of the present invention is to provide a metal layer-integrated polypropylene film having the polypropylene film, and a film capacitor having the metal layer-integrated polypropylene film, as well as their production methods.

### Solution to Problem

The present inventors conducted extensive research on polypropylene films. As a result, the present inventors found that a polypropylene film, wherein a polypropylene resin constituting the polypropylene film has specific ranges of a molecular weight distribution (Mw/Mn) of weight average molecular weight Mw to number average molecular weight Mn, a Z-average molecular weight Mz, and a weight fraction w when the logarithmic molecular weight Log(M) = 4.0 in an integral molecular weight distribution curve, has the above film performance, and a capacitor using the polypropylene film has the above capacitor performance. Thus, the polypropylene film and film capacitor of the present invention have been completed. The present inventors also found that the polypropylene film can be suitably produced by a production method comprising melting a polypropylene resin composition at a specific shear rate.

Specifically, the present invention relates to a polypropylene film, a metal layer-integrated polypropylene film, and a film capacitor, as defined in the present claims.

### Advantageous Effects of Invention

In the polypropylene film of the present invention, the polypropylene resin constituting the film has specific ranges of a molecular weight distribution (Mw/Mn) of weight average molecular weight Mw to number average molecular weight Mn, a Z-average molecular weight Mz, and a weight fraction w when the logarithmic molecular weight Log(M) = 4.0 in an integral molecular weight distribution curve, whereby even when the film thickness is as thin as 6.0 µm or less, the film has excellent dielectric breakdown strength when a direct voltage is applied at a high temperature of about 120°C (100°C to 120°C), and excellent dielectric breakdown strength when an alternating voltage is applied, and also has excellent heat shrinkage resistance in terms of suppressing heat shrinkage in the machine direction (MD) at temperatures up to about 150°C exceeding the above high temperature. Further, the film capacitor of the present invention, which uses the polypropylene film as a capacitor derivative, has excellent heat resistance at a high temperature of about 120°C (100°C to 120°C) . Specifically, the film capacitor of the present invention has excellent lifetime performance in terms of suppressing the decrease in the capacitance of the capacitor even after use for a long period of time at the above high temperature, and has excellent heat shock resistance in terms of suppressing heat tightening (deformation) of the capacitor in repeated use between the above high temperature, assuming inside the engine room, and a low temperature. Therefore, the polypropylene film of the present invention is preferably for use in film capacitors.

### Brief Description of Drawings

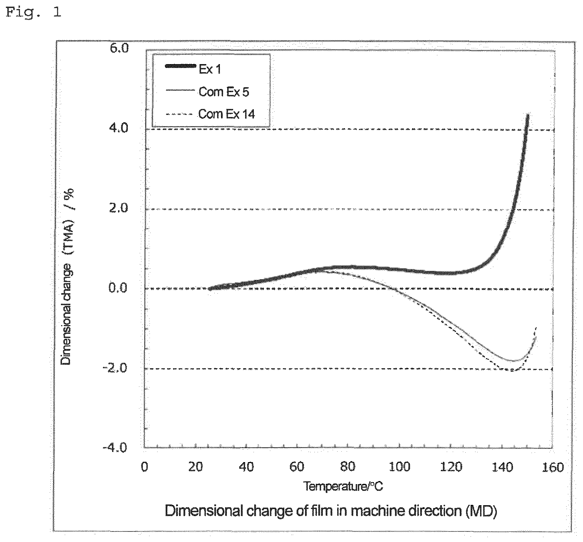

Fig. 1 shows the results of thermomechanical analysis (TMA) of the polypropylene films produced in Example 1, Comparative Example 5, and Comparative Example 14, and the results of drawing a TMA curve with the temperature on the horizontal axis and the dimensional change of the film in the machine direction (MD) on the vertical axis.

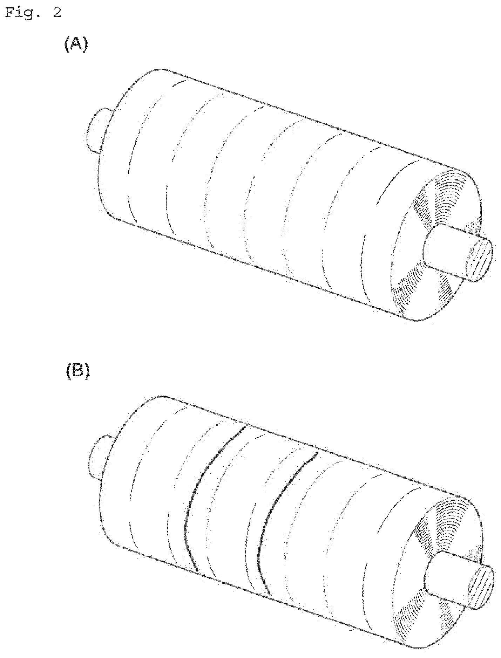

Fig. 2 shows schematic diagrams each showing the appearance of a large roll excluding about 100 mm at both ends after aging. In the figure, (A) is a schematic diagram showing a case where there is no defect line (vertical defect line) in the circumferential direction with a depth of 0.5 mm or more, and (B) is a schematic diagram schematically showing a case where there are two defect lines (vertical defect lines) in the circumferential direction with a depth of 0.5 mm or more.

### Description of Embodiments

The polypropylene film, metal layer-integrated polypropylene film, and film capacitor of the present invention, as well as their production methods are described in detail below.

In the present specification, polypropylene may be abbreviated as "PP," and polypropylene resin may be abbreviated as "PP resin."

In the present specification, the terms "comprise" and "contain" include the concepts of "comprise," "contain," "essentially consist of," and "consist of."

In the present specification, the term "capacitor" includes the concepts of "capacitor," "capacitor element," and "film capacitor."

In the present specification, the directions of the polypropylene film are as follow. First, the machine direction of the film is the same as the machine direction (hereinafter referred to as "MD direction"). The MD direction is also referred to as the length direction or the flow direction. Next, the lateral direction of the film is the same as the transverse direction (hereinafter referred to as "TD direction"). The TD direction is also referred to as the width direction.

### Polypropylene Film

The polypropylene film of the present invention is characterized in that the polypropylene resin constituting the polypropylene film has:
- a molecular weight distribution (Mw/Mn) of weight average molecular weight Mw to number average molecular weight Mn of 5.0 or more and 6.9 or less;
- a Z-average molecular weight Mz of 650,000 or more and 945,000 or less; and
- a weight fraction w of 2.6% or more 4.2% or less when the logarithmic molecular weight Log(M) = 4.0 in an integral molecular weight distribution curve.
Hereinafter, these are abbreviated, for example, as "Mw," "Mn," "molecular weight distribution (Mw/Mn)," "Mz," and "weight fraction w."

In the polypropylene film of the present invention, which has the above characteristics, the polypropylene resin constituting the film has specific ranges of a molecular weight distribution (Mw/Mn) of weight average molecular weight Mw to number average molecular weight Mn, a Z-average molecular weight Mz, and a weight fraction w when the logarithmic molecular weight Log(M) = 4.0 in an integral molecular weight distribution curve, whereby even when the film thickness is as thin as 6.0 µm or less, the film has excellent dielectric breakdown strength when a direct voltage is applied at a high temperature of about 120°C (100°C to 120°C), and excellent dielectric breakdown strength when an alternating voltage is applied, and also has excellent heat shrinkage resistance in terms of suppressing heat shrinkage in the machine direction (MD) at temperatures up to about 150°C exceeding the above high temperature. Further, the film capacitor of the present invention, which uses the polypropylene film as a capacitor derivative, has excellent heat resistance at a high temperature of about 120°C (100°C to 120°C) . Specifically, the film capacitor of the present invention has excellent lifetime performance in terms of suppressing the decrease in the capacitance of the capacitor even after use for a long period of time at the above high temperature, and has excellent heat shock resistance in terms of suppressing heat tightening (deformation) of the capacitor in repeated use between the above high temperature, assuming inside the engine room, and a low temperature. Therefore, the polypropylene film of the present invention is preferably for use in film capacitors. Further, although the presence of stretching in the polypropylene film of the present invention is not limited, considering the above applications, the polypropylene film of the present invention is preferably a biaxially stretched film.

Both surfaces of the polypropylene film of the present invention can be defined as a first surface and a second surface. The first surface can be a rough surface. When the first surface is a rough surface, element winding in the production of capacitors is less likely to result in wrinkles. The second surface can also be a rough surface.

The thickness of the polypropylene film is preferably 0.8 µm or more and 6.0 µm or less, in terms of ensuring, when used in a capacitor, the smaller size and higher capacitance of the capacitor. Specifically, the thickness of the polypropylene film is preferably 5.5 µm or less, more preferably 3.5 um or less, even more preferably 3.0 µm or less, and particularly preferably 2.4 µm or less. Further, the thickness of the polypropylene film is preferably 1.0 µm or more, more preferably 1.8 µm or more, and even more preferably 2.2 µm or more, in terms of production. The method for measuring the thickness of the polypropylene film in the present specification is as described in the Examples.

The density of the polypropylene film is not limited, but is preferably set to, for example, 919 g/cm³ or more and 925 g/cm³ or less, in consideration of capacitor application. The method for measuring the density of the polypropylene film in the present specification is as described in the Examples.

In the polypropylene film of the present invention, the molecular weight distribution (Mw/Mn) of the polypropylene resin constituting the polypropylene film (if the polypropylene resin comprises a mixture of multiple resins, after mixing) is 5.0 or more and 6.9 or less.

The molecular weight distribution (Mw/Mn) may be 5.0 or more and 6.9 or less; however, the lower limit value is preferably 5.2 or more, more preferably 5.6 or more, even more preferably 5.8 or more, even more preferably 6.0 or more, even more preferably 6.2 or more, and still even more preferably 6.3 or more. The upper limit value is preferably 6.8 or less, more preferably 6.7 or less, and even more preferably 6.6 or less. Because the molecular weight distribution (Mw/Mn) is within the above ranges, polypropylene films having excellent dielectric breakdown strength at high temperatures and reduced heat shrinkage in the machine direction (MD) can be obtained as an effect of the combination with other requirements.

In the polypropylene film of the present invention, the Mz of the polypropylene resin constituting the polypropylene film (if the polypropylene resin comprises a mixture of multiple resins, after mixing) is 650,000 or more and 945,000 or less.

The Mz may be 650,000 or more and 945,000 or less; however, the lower limit value is preferably more than 700,000, more preferably 710,000 or more, and even more preferably 720,000 or more. The upper limit value is preferably 920,000 or less, more preferably 850,000 or less, and even more preferably 790,000 or less. Because the Mz is within the above ranges, polypropylene films having excellent dielectric breakdown strength at high temperatures and particularly reduced heat shrinkage in the machine direction (MD) can be obtained as an effect of the combination with other requirements. If the Mz exceeds 945,000, which is outside the range of the present invention, the heat shrinkage of polypropylene films at high temperatures is likely to increase.

In the polypropylene film of the present invention, the weight fraction w is 2.6% or more and 4.2% or less when the logarithmic molecular weight Log(M) = 4.0 in the integral molecular weight distribution curve of the polypropylene resin constituting the polypropylene film (if the polypropylene resin comprises a mixture of multiple resins, after mixing).

The weight fraction w may be 2.6% or more and 4.2% or less; however, the lower limit value is preferably 2.8% or more, more preferably 3.0% or more, even more preferably 3.2% or more, and still even more preferably 3.4% or more. The upper limit value is preferably 4.1% or less, more preferably 4.0% or less, even more preferably 3.7% or less, and still even more preferably 3.6% or less. Because the weight fraction w is within the above ranges, polypropylene films having excellent dielectric breakdown strength at high temperatures and reduced heat shrinkage in the machine direction (MD) can be obtained as an effect of the combination with other requirements. Further, because the weight fraction w is within the above ranges, the film capacitor of the present invention, which uses the polypropylene film as a capacitor derivative, has excellent heat shock resistance in terms of suppressing heat tightening (deformation) of the capacitor in repeated use between high and low temperatures.

In a preferred embodiment of the polypropylene film of the present invention, the polypropylene resin constituting the polypropylene film (if the polypropylene resin comprises a mixture of multiple resins, after mixing) can be as follows:
- the molecular weight distribution (Mw/Mn) is 5.0 or more and 6.6 or less;
- the Mz is 720,000 or more and 850,000 or less; and
- the weight fraction w is 3.3% or more and 3.7% or less.
The use of polypropylene resins having such physical properties makes it easier to obtain polypropylene films having excellent dielectric breakdown strength at high temperatures and reduced heat shrinkage in the machine direction (MD).

In a more preferred embodiment of the polypropylene film of the present invention, the polypropylene resin constituting the polypropylene film (if the polypropylene resin comprises a mixture of multiple resins, after mixing) can be as follows:
- the molecular weight distribution (Mw/Mn) is 5.0 or more and 6.6 or less;
- the Mz is 720,000 or more and 790,000 or less; and
- the weight fraction w is 3.5% or more and 3.7% or less.
The use of polypropylene resins having such physical properties makes it easier to obtain polypropylene films having excellent dielectric breakdown strength at high temperatures and reduced heat shrinkage in the machine direction (MD).

The methods for measuring the Mw, Mn, Mz, molecular weight distribution (Mw/Mn), and weight fraction w of the polypropylene resin constituting the polypropylene film in the present specification, as well as the Mw, Mn, Mz, molecular weight distribution (Mw/Mn), molecular weight distribution (Mz/Mn), differential molecular weight distribution value when the logarithmic molecular weight Log(M) = 4.5, differential molecular weight distribution value when the logarithmic molecular weight Log(M) = 6.0, difference in differential molecular weight distribution (D_{M}), and weight fraction w of polypropylene resins A and B when the polypropylene resin comprises multiple resins, are as described in the Examples.

The polypropylene film of the present invention comprises a polypropylene resin. The content of the polypropylene resin is preferably 90 wt.% or more, and more preferably 95 wt.% or more, based on the entire polypropylene film (when the entire polypropylene film is taken as 100 wt.%). The upper limit of the content of the polypropylene resin is, for example, 100 wt.% or 98 wt.%, based on the entire polypropylene film.

The total ash content of the polypropylene resin is preferably less for electrical characteristics. The total ash content is preferably 50 ppm or less, more preferably 40 ppm or less, and even more preferably 30 ppm or less, based on the polypropylene resin. The lower limit of the total ash content is, for example, 2 ppm or 5 ppm. A less total ash content means that there are less impurities, such as polymerization catalyst residues.

The polypropylene resin may comprise a single polypropylene resin alone or two or more polypropylene resins.

When two or more polypropylene resins are contained in the polypropylene film of the present invention, the polypropylene resin with the highest content is defined as a main component in the present specification, and is referred to as "the polypropylene resin as the main component" or "the base resin" in the present specification. Further, when a single polypropylene resin is contained in the polypropylene film, the polypropylene resin is also defined as a main component in the present specification, and is referred to as "the polypropylene resin as the main component" in the present specification.

When the polypropylene film of the present invention contains two or more (in particular, two) polypropylene resins, for example, the film may contain the following polypropylene resin A (base resin as the main component) and the following polypropylene resin B (blend resin). A case where two polypropylene resins, i.e., polypropylene resin A (base resin) and polypropylene resin B (blend resin), are used is illustratively described below.

The content of the polypropylene resin A is more than 50 wt.%, preferably 55 wt.% or more, more preferably 60 wt.% or more, and even more preferably 65 wt.% or more, based on 100 wt.% of the polypropylene resin. The upper limit of the content of the polypropylene resin A is less than 100 wt.%, preferably 95 wt.% or less, more preferably 90 wt.% or less, even more preferably 80 wt.% or less, and still even more preferably 75 wt.% or less, based on 100 wt.% of the polypropylene resin. Examples of the polypropylene resin A include isotactic polypropylene.

The weight average molecular weight Mw of the polypropylene resin A is preferably 250,000 or more and less than 350,000, more preferably 280,000 or more and less than 350,000, and even more preferably 280,000 or more and 340,000 or less. When the Mw is 250,000 or more and less than 350,000, it is easy to control the thickness of the cast sheet in the production process of the polypropylene film, and thickness unevenness is less likely to occur.

The number average molecular weight Mn of the polypropylene resin A is preferably 30,000 or more and 54,000 or less, more preferably 33,000 or more and 52,000 or less, and even more preferably 33,000 or more and 47,000 or less. When the Mn is 30,000 or more and 54,000 or less, capacitor elements having low heat shrinkage and excellent heat shock resistance can be easily obtained.

The z-average molecular weight Mz of the polypropylene resin A is preferably 700,000 or more and 1.55 million or less, and more preferably 750,000 or more and 1.5 million or less. When the Mz is 700,000 or more and 1.55 million or less, films having high dielectric breakdown strength at high temperatures can be easily obtained.

The molecular weight distribution (Mw/Mn) of the polypropylene resin A is preferably 5.0 or more, more preferably 5.5 or more, and even more preferably 6.0 or more. The Mw/Mn of the polypropylene resin A is preferably 10.0 or less, and more preferably 9.5 or less. When the Mw/Mn is 5.0 or more and 10.0 or less, stretchability is improved, and thin films can be easily obtained.

The molecular weight distribution (Mz/Mn) of the polypropylene resin A is preferably 10 or more and 70 or less, more preferably 15 or more and 60 or less, and even more preferably 15 or more and 50 or less. When the Mz/Mn is 10 or more and 70 or less, stretchability is improved, and thin films can be easily obtained.

In the molecular weight distribution curve of the polypropylene resin A, the differential molecular weight distribution value when the logarithmic molecular weight Log(M) = 4.5 is preferably 28.0 or more. The upper limit value is preferably 32.0 or less. Moreover, the differential molecular weight distribution value when the logarithmic molecular weight Log(M) = 6.0 is preferably 17.0 or more, and more preferably 20.0 or more. The upper limit value is preferably 24.0 or less, and more preferably 22.0 or less. Further, the difference obtained by subtracting the differential molecular weight distribution value when the logarithmic molecular weight Log(M) = 6.0 from the differential molecular weight distribution value when the logarithmic molecular weight Log(M) = 4.5 (difference in differential molecular weight distribution (D_{M})) is preferably 8.0 or more and 18.0 or less, more preferably 8.0 or more and 11.0 or less, even more preferably 8.2 or more and 10.0 or less, and still even more preferably 8.4 or more and 8.8 or less.

When a component at a logarithmic molecular weight Log(M) = 4.5 as a representative distribution value of components having a molecular weight of 10,000 to 100,000 (hereinafter also referred to as "low-molecular-weight components") lower than the Mw value of the polypropylene resin A (250,000 or more and less than 350,000) is compared with a component at around Log(M) = 6.0 as a representative distribution value of components having a molecular weight of around 1 million (hereinafter also referred to as "high-molecular-weight components") higher than the Mw value of the polypropylene resin A, it is understood that the content of the low-molecular-weight components is larger at a ratio of 8.0% or more and 18.0% or less.

That is, a molecular weight distribution Mw/Mn of 5.0 to 10.0 merely indicates the width of the molecular weight distribution, and does not indicate the quantitative relationship between the high- and low-molecular-weight components within the distribution. Accordingly, the polypropylene resin A according to the present invention preferably has a broad molecular weight distribution and contains components having a molecular weight from 10,000 to 100,000 at a larger ratio of 8.0% or more and 18.0% or less in comparison with components having a molecular weight of 1 million. This is preferable because the crystallite size is reduced, and the polypropylene film tends to have a roughened surface.

The lower limit value of the weight fraction w of the polypropylene resin A is preferably 3.8% or more, and more preferably 4.0% or more. The upper limit value is preferably 4.4% or less, and more preferably 4.2% or less. Because the weight fraction w of the polypropylene resin A is within the above ranges, and the weight fraction w of a mixture of the polypropylene resin A and a polypropylene resin B, described later, is 2.6% or more and 4.2% or less due to the combination with the weight fraction w of the polypropylene resin B, polypropylene films having excellent dielectric breakdown strength at high temperatures and reduced heat shrinkage in the machine direction (MD) can be easily obtained.

The melt flow rate (MFR_{A}) of the polypropylene resin A at 230°C is preferably 4.8 g/10 min or more, more preferably 5.0 g/10 min or more, and even more preferably 5.5 g/10 min or more. Further, the upper limit of MFR_{A} is preferably 10.0 g/10 min or less, more preferably 8.0 g/10 min or less, and even more preferably 6.0 g/10 min or less. MFR_{A} can be set to 4.8 g/10 min or more and 5.5 g/10 min or less. The method for measuring the melt flow rate (MFR) in the present specification is as described in the Examples. The unit "g/10 min" of the melt flow rate is also referred to as "dg/min."

In a preferred embodiment of the polypropylene film of the present invention, the polypropylene resin A can be as follows:
- the polypropylene resin A has a Mw of 275,000 or more and less than 350,000;
- the polypropylene resin A has a molecular weight distribution (Mw/Mn) of 5.8 or more and 10.0 or less; and
- the polypropylene resin A has a melt flow rate (MFR_{A}) of 4.8 g/10 min or more and 5.5 g/10 min or less.
The use of the polypropylene resin A having such physical properties makes it easy to mold a cast sheet (stretch precursor) by an extruder.

In a more preferred embodiment of the polypropylene film of the present invention, the polypropylene resin A can be as follows:
- the polypropylene resin A has a Mw of 280,000 or more and 300,000 or less;
- the polypropylene resin A has a molecular weight distribution (Mw/Mn) of 6.0 or more and 6.5 or less; and
- the polypropylene resin A has a melt flow rate (MFR_{A}) of 5.0 g/10 min or more and 5.5 g/10 min or less.

The heptane insoluble of the polypropylene resin A is preferably 97.0% or more. The heptane insoluble is preferably 98.5% or less. A higher heptane insoluble indicates higher resin stereoregularity. When the heptane insoluble (HI) is 97.0% or more and 98.5% or less, the moderately high stereoregularity moderately enhances the crystallinity of the polypropylene resin in the polypropylene film, and increases dielectric breakdown strength at high temperatures. Furthermore, the rate of solidification (crystallization) is moderate during molding of the cast sheet in the production process of the polypropylene film, and moderate stretchability is imparted. The method for measuring the heptane insoluble (HI) in the present specification is as described in the Examples.

The total ash content of the polypropylene resin A is preferably less for electrical characteristics. The total ash content is preferably 50 ppm or less, more preferably 40 ppm or less, and even more preferably 30 ppm or less, based on the polypropylene resin A. The lower limit of the total ash content is, for example, 2 ppm or 5 ppm.

The content of the polypropylene resin B is less than 50 wt.%, preferably 49 wt.% or less, more preferably 40 wt.% or less, and particularly preferably 35 wt.% or less, based on 100 wt.% of the polypropylene resin. The lower limit of the content of the polypropylene resin B is, for example, preferably 10 wt.% or more, more preferably 15 wt.% or more, and even more preferably 25 wt.% or more, based on 100 wt.% of the polypropylene resin. Examples of the polypropylene resin B include isotactic polypropylene. In a particularly preferred embodiment of the present invention, the ratio of the mass of the polypropylene resin A to the total mass of the polypropylene resins A and B is 65 mass% or more and 75 mass% or less.

The Mw of the polypropylene resin B is preferably 350,000 or more, and more preferably 390,000 or more. The Mw of the polypropylene resin B is preferably 550,000 or less, more preferably 450,000 or less, and even more preferably 400,000 or less. When the Mw is 350,000 or more and 550,000 or less, in the production process of the polypropylene film, it is easy to control the thickness of the cast sheet in the production process of the polypropylene film, and thickness unevenness is less likely to occur.

The Mn of the polypropylene resin B is preferably 40,000 or more and 54,000 or less, more preferably 42,000 or more and 50,000 or less, and even more preferably 44,000 or more and 48,000 or less. When the Mn is 40,000 or more and 54,000 or less, capacitor elements having low heat shrinkage and excellent heat shock resistance can be easily obtained.

The Mz of the polypropylene resin B is preferably more than 1.55 million and 2 million or less, and more preferably 1.58 million or more and 1.7 million or less. When the Mz is more than 1.55 million and 2 million or less, films having high dielectric breakdown strength at high temperatures can be easily obtained.

The molecular weight distribution (Mw/Mn) of the polypropylene resin B is preferably 5.0 or more, more preferably 5.5 or more, even more preferably 7.0 or more, and still even more preferably 7.5 or more. The upper limit of the Mw/Mn of the polypropylene resin B is, for example, 11.0 or less, preferably 10.0 or less, and more preferably 8.5 or less. When the Mw/Mn is 5.0 or more and 11.0 or less, stretchability is improved, and thin films can be easily obtained.

The molecular weight distribution (Mz/Mn) of the polypropylene resin B is preferably 30 or more and 40 or less, and more preferably 33 or more and 36 or less. When the Mz/Mn is 30 or more and 40 or less, stretchability is improved, and thin films can be easily obtained.

In the molecular weight distribution curve of the polypropylene resin B, the differential molecular weight distribution value when the logarithmic molecular weight Log(M) = 4.5 is preferably 24.0 or more, and more preferably 27.0 or more. The upper limit value is preferably 35.0 or less, and more preferably 32.0 or less. Moreover, the differential molecular weight distribution value when the logarithmic molecular weight Log(M) = 6.0 is preferably 28.0 or more, and more preferably 30.0 or more. The upper limit value is preferably 35.0 or less, and more preferably 33.0 or less. Further, the difference obtained by subtracting the differential molecular weight distribution value when the logarithmic molecular weight Log(M) - 6.0 from the differential molecular weight distribution value when the logarithmic molecular weight Log(M) = 4.5 (difference in differential molecular weight distribution (D_{M})) is preferably - 11.0 or more and 7.0 or less, more preferably -6.0 or more and 0.0 or less, and even more preferably -4.0 or more and -2.0 or less.

When the polypropylene resin comprises the polypropylene resins A and B, due to the differences in the Mw, Mw/Mn, and differential molecular weight distribution value difference between the polypropylene resins A and B, i.e., the difference in the composition of the molecular weight distribution, the polypropylene film obtained by mixing and molding has a slightly different quantitative relationship between the high- and low-molecular-weight components. It is thus considered preferable because it takes a certain kind of finely mixed (phase-separated) state and the crystal size can be easily reduced. Furthermore, even at the same stretching ratio, high orientation tends to be obtained, which is considered preferable because it is easy to obtain a finely roughened surface. When the polypropylene resin comprises the polypropylene resins A and B, the present invention is considered to exhibit excellent effects for the reasons stated above; however, the present invention is not limited by those reasons.

The lower limit value of the weight fraction w of the polypropylene resin B is preferably 2.0% or more, and more preferably 3.0% or more. The upper limit value is preferably 5.0% or less, and more preferably 4.2% or less. Because the weight fraction w of the polypropylene resin B is within the above ranges, and the weight fraction w of a mixture of the polypropylene resin A, described above, and the polypropylene resin B is 2.6% or more and 4.2% or less due to the combination with the weight fraction w of the polypropylene resin A, polypropylene films having excellent dielectric breakdown strength at high temperatures and reduced heat shrinkage in the machine direction (MD) can be easily obtained.

The melt flow rate (MFR_{B}) of the polypropylene resin B at 230°C is preferably 4.5 g/10 min or less, more preferably 4.0 g/10 min or less, even more preferably 3.0 g/10 min or less, and still even more preferably 2.1 g/10 min or less. The lower limit of the MFR_{B} is preferably 0.1 g/10 min or more, more preferably 0.5 g/10 min or more, and even more preferably 1.5 g/10 min or more.

The difference MFR_{A}-MFR_{B} between the MFR_{A} of the polypropylene resin A as the base resin as the main component and the MFR_{B} of the polypropylene resin B as the blend resin is preferably set to 1.5 g/10 min or more. That is, MFR_{A} is greater than MFR_{B}. The difference MFR_{A}-MFR_{B} is preferably 1.6 g/10 min or more, more preferably 2.0 g/10 min or more, and even more preferably 3.0 g/10 min or more. If the difference MFR_{A}-MFR_{B} is less than 1.5 g/10 min (the values less than 1.5 g/10 min include negative values), a sea-island phase-separated structure is not formed during molding of the cast sheet in the production process of the polypropylene film, or even if it is formed, the island size is very small; thus, finally, polypropylene films having excellent dielectric breakdown strength at high temperatures may be less likely to be obtained. In particular, even when the difference between MFR_{A} and MFR_{B} is large, if MFR_{B} is larger (if the difference MFR_{A}-MFR_{B} is negative), the island size of the sea-island phase-separated structure is very small.

In a preferred embodiment of the polypropylene film of the present invention, the polypropylene resin B can be as follows:
- the polypropylene resin B has a Mw of 385,000 or more and 550,000 or less;
- the polypropylene resin B has a molecular weight distribution (Mw/Mn) of 8.4 or more and 11.0 or less; and
- the polypropylene resin B has a melt flow rate (MFR_{B}) of 0.1 g/10 min or more and 2.2 g/10 min or less.
The use of the polypropylene resin B having such physical properties makes it easy to mold a cast sheet (stretch precursor) by an extruder.

In a more preferred embodiment of the polypropylene film of the present invention, the polypropylene resin B can be as follows:
- the polypropylene resin B has a Mw of 390,000 or more and 550,000 or less;
- the polypropylene resin B has a molecular weight distribution (Mw/Mn) of 8.5 or more and 11.0 or less; and
- the polypropylene resin B has a melt flow rate (MFR_{B}) of 1.0 g/10 min or more and 2.1 g/10 min or less.

The heptane insoluble of the polypropylene resin B is preferably 97.5% or more, more preferably 98.0% or more, even more preferably more than 98.5%, and particularly preferably 98.6% or more. Further, the heptane insoluble is preferably 99.5% or less, and more preferably 99.0% or less.

The total ash content of the polypropylene resin B is preferably less for electrical characteristics. The total ash content is preferably 50 ppm or less, more preferably 40 ppm or less, and even more preferably 30 ppm or less, based on the polypropylene resin B. The lower limit of the total ash content is, for example, 2 ppm or 5 ppm.

The case in which two polypropylene resins, i.e., polypropylene resin A (base resin) and polypropylene resin B (blend resin), are used is illustratively described above; however, in the present invention, the polypropylene film may comprise resins other than polypropylene resins. In that case, the total amount of the polypropylene resins A and B can be, for example, 90 wt.% or more, 95 wt.% or more, or 100 wt.%, based on the entire resin, which is taken as 100 wt.%.

The polypropylene film of the present invention may further contain additives. Examples of additives include antioxidants, chlorine absorbers, ultraviolet absorbers, lubricants, plasticizers, flame-retardant agents, antistatic agents, coloring agents, and the like.

The polypropylene film of the present invention may be a biaxially stretched film, a uniaxially stretched film, or an unstretched film, but is preferably a biaxially stretched film.

The polypropylene film of the present invention is preferably for use in capacitors. Specifically, it can be suitably used as a capacitor dielectric. As described later, the polypropylene film of the present invention can be formed as a metal layer-integrated polypropylene film having a metal layer laminated on one or both sides of the film. A film capacitor can be produced by winding the metal layer-integrated polypropylene film or by laminating a plurality of the metal layer-integrated polypropylene films.

In consideration of the capacitor application mentioned above, the polypropylene film of the present invention preferably has the following dielectric breakdown strength and heat shrinkage resistance.

The dielectric breakdown strength at alternating voltage at 100°C (V_{ACl00°C}) of the polypropylene film of the present invention is preferably 240 V/um or more, more preferably 245 V/µm or more, and even more preferably 250 V/µm or more. The upper limit of the dielectric breakdown strength at alternating voltage at 100°C is preferably higher, and is, for example, 270 V/um or 265 V/um.

The dielectric breakdown strength at alternating voltage at 110°C (V_{AC110°C}) of the polypropylene film of the present invention is preferably 240 V/um or more, more preferably 242 V/µm or more, and even more preferably 244 V/µm or more. The upper limit of the dielectric breakdown strength at alternating voltage at 110°C is preferably higher, and is, for example, 260 V/um or 255 V/µm.

The dielectric breakdown strength at alternating voltage at 120°C (V_{AC120°C}) of the polypropylene film of the present invention is preferably 230 V/µm or more, more preferably 235 V/um or more, and even more preferably 238 V/µm or more. The upper limit of the dielectric breakdown strength at alternating voltage at 120°C is preferably higher, and is, for example, 250 V/µm or 245 V/um.

The dielectric breakdown strength at direct voltage at 120°C (V_{DC120°C}) of the polypropylene film of the present invention is preferably 520 V/µm or more, more preferably 527 V/µm or more, and even more preferably 532 V/um or more. The upper limit of the dielectric breakdown strength at direct voltage at 120°C is preferably higher, and is, for example, 550 V/µm or 540 V/um.

The total value of V_{AC120°C} and V_{DC120°C} (V_{AC120°C}+V_{DC120°C}) of the polypropylene film of the present invention is preferably 750 V/µm or more, more preferably 760 V/µm or more, and even more preferably 770 V/µm or more. The upper limit of the total value of V_{AC120°C} and V_{DC120°C} is preferably higher, and is, for example, 1000 V/µm, 900 V/µm, or 850 V/um.

The difference between V_{DC120°C} and V_{AC120°C} (V_{DC120°C}-V_{AC120°C}) of the polypropylene film of the present invention is preferably 300 V/um or less. Since the difference is thus relatively small, there is an advantage that dielectric breakdown is less likely to occur even for a superimposed current (current in which direct and alternating currents are superimposed). The lower limit value of the difference is preferably 280 V/µm or more, and the difference can be set to, for example, 280 V/um or more and 300 V/um or less.

The polypropylene film of the present invention has excellent heat shrinkage resistance. Specifically, in thermomechanical analysis (TMA) of the polypropylene film, when heating is performed from 25°C to 155°C at a rate of 10°C/min under a load of 2.17 N/mm², and a TMA curve is drawn with the temperature on the horizontal axis and the dimensional change of the film in the machine direction (MD) on the vertical axis, the dimensional change is preferably 0% or more in the heating process from 25°C to 155°C. A dimensional change of 0% or more (i.e., not less than 0%) means that there is no heat shrinkage. The method of thermomechanical analysis (TMA) is as described in the Examples.

Fig. 1 shows the results of thermomechanical analysis of the polypropylene films produced in Example 1, Comparative Example 5, and Comparative Example 14, and the results of drawing a TMA curve with the temperature on the horizontal axis and the dimensional change of the film in the machine direction (MD) on the vertical axis. As can be seen from Fig. 1, the dimensional change of the polypropylene film produced in Example 1 in the machine direction of the film is 0% or more in the entire heating process from 25°C to 155°C. On the other hand, regarding the polypropylene films produced in Comparative Examples 5 and 14, there are temperature regions in which the dimensional change of the film in the machine direction is less than 0% in the heating process from 25°C to 155°C.

### Method for Producing Polypropylene Film

The method for producing the polypropylene film of the present invention is not limited. For example, the polypropylene film of the present invention can be suitably produced by the following production method (hereinafter referred to as "the method for producing the polypropylene film of the present invention").

The method for producing the polypropylene film of the present invention is characterized by comprising melting a polypropylene resin composition comprising at least polypropylene resins A and B at a temperature of 225°C or higher and 270°C or lower and a shear rate of 2000 s⁻¹ or more and 15000 s⁻¹ or less;
the difference MFR_{A}-MFR_{B} between the melt flow rate (MFR_{A}) of the polypropylene resin A and the melt flow rate (MFR_{B}) of the polypropylene resin B being 1.5 g/10 min or more; and
the content of the polypropylene resin A in the polypropylene resin composition being larger than the content of the polypropylene resin B in the polypropylene resin composition.

The production method makes it possible to provide a polypropylene film having good dielectric breakdown strength at high temperatures. The reason for this is considered to be due to the sea-island phase-separated structure (in particular, the appropriate island size) of the cast sheet due to the use of two different polypropylene resins.

In the method for producing the polypropylene film of the present invention, a polypropylene resin composition comprising at least polypropylene resins A and B is used. The larger content of the polypropylene resin A in the polypropylene resin composition than the content of the polypropylene resin B in the polypropylene resin composition means that in the relationship between the polypropylene resins A and B, the polypropylene resin A is a base resin as the main component, and the polypropylene resin B is a blend resin for the base resin. The terms "polypropylene resin A" and "polypropylene resin B" in the method for producing the polypropylene film of the present invention correspond, respectively, to the terms "polypropylene resin A" and "polypropylene resin B" in the "Polypropylene Film" section above. The explanations of the Mw, Mn, Mz, molecular weight distribution (Mw/Mn), molecular weight distribution (Mz/Mn), differential molecular weight distribution value when the logarithmic molecular weight Log(M) = 4.5, differential molecular weight distribution value when the logarithmic molecular weight Log(M) = 6.0, difference in differential molecular weight distribution (D_{M}), weight fraction w, and MFR of each resin are as described above; however, in the method for producing the polypropylene resin of the present invention, those in which the difference MFR_{A}-MFR_{B} between MFR_{A} and MFR_{B} is 1.5 g/10 min or more are particularly used.

The method for mixing the resins applied to the production method of the present invention is not particularly limited. Examples of the method include a method comprising dryblending a polymer powder or pellets of the base resin and the blend resin using a mixer etc.; and a method comprising supplying a polymer powder or pellets of the base resin and the blend resin to a kneader, followed by melting and kneading to thereby obtain a kneaded product.

The mixer and kneader are not particularly limited. The kneader can be any of a single-screw type kneader, a two-screw type kneader, or a multi-screw type kneader having three or more screws. When a kneader having two or more screws is used, the type of kneading may be rotation in the same direction or different directions.

In the case of kneading by melting and kneading, the kneading temperature is not particularly limited, as long as a good kneaded product is obtained. The temperature is generally within a range of 200°C or higher and 300°C or lower, and preferably 230°C or higher and 270°C or lower, in terms of preventing resin degradation. In order to prevent resin degradation during kneading and mixing, the kneader may be purged with an inert gas, such as nitrogen. The molten kneaded resin may be pelletized into a suitable size using a commonly known pelletizer. As a result, mixed polypropylene raw material resin pellets can be obtained.

The total ash content derived from polymerization catalyst residues etc. contained in the polypropylene raw material resin is preferably as low as possible, in order to improve electrical characteristics. The total ash content is preferably 50 ppm or less, more preferably 40 ppm or less, and particularly preferably 30 ppm or less, based on 100 parts by weight of the polypropylene resin.

The polypropylene resin may further contain additives. The "additives" are not particularly limited, as long as they are generally used for polypropylene resins. Examples of additives include antioxidants, chlorine absorbers, ultraviolet absorbers, lubricants, plasticizers, flame-retardant agents, antistatic agents, etc. The polypropylene resin may contain such additives in an amount that does not adversely affect the polypropylene film.

In the method for producing the polypropylene film of the present invention, first, polypropylene resin pellets, dry-mixed polypropylene resin pellets, or mixed polypropylene resin pellets prepared by melt-kneading beforehand are supplied to an extruder, and heated and melted.

The polypropylene resin composition is allowed to melt at 225°C or higher and 270°C or lower. Specifically, the set temperature of the extruder is set to 225°C or higher and 270°C or lower during heat-melting of the polypropylene resin composition. As a result, on the assumption that the specific polypropylene resin composition is used, a sea-island phase-separated structure is formed at the time of molding a cast sheet, described later, and a polypropylene film having excellent dielectric breakdown strength at high temperatures can finally be obtained.

The polypropylene resin composition is allowed to melt at a shear rate of 2000 s⁻¹ or more and 15000s⁻¹ or less while maintaining the composition at a temperature of 225°C or higher and 270°C or lower. As a result, on the assumption that the specific polypropylene resin composition is used, a sea-island phase-separated structure is formed at the time of molding a cast sheet, described later, and a polypropylene film having excellent dielectric breakdown strength at high temperatures can finally be obtained. If the shear rate is less than 2000 s⁻¹, the extrusion amount is not constant, and the shape and dimensions of the cast sheet become irregular or fluctuate regularly, and breakage during transportation of the cast sheet and breakage during stretching are likely to occur.

If the shear rate exceeds 15000 s⁻¹, unmelted materials are extruded in the extruder by a phenomenon called "breakup," and a uniform cast sheet cannot be obtained, which tends to lead to breakage during stretching. Alternatively, excessive heat is generated when passing through the tip clearance, and the polypropylene resin composition is significantly deteriorated. Therefore, even if a uniform cast sheet is obtained, the film obtained by stretching has lowered dielectric breakdown strength. The shear rate can be adjusted by adjusting the cylinder diameter and screw rotation speed of the extruder and the groove depth of the screw.

The shear rate may be 2000 s⁻¹ or more and 15000 s⁻¹ or less, but is preferably 2000 s⁻¹ or more and 10000 s⁻¹ or less, and more preferably 2000 s⁻¹ or more and 2300 s⁻¹ or less. Because the shear rate is within the above ranges, polypropylene films having a weight fraction w of 2.6% or more and 4.2% or less can be easily obtained. Due to the combination with other requirements, a film capacitor that uses the polypropylene film as a capacitor derivative has excellent heat shock resistance in terms of suppressing heat tightening (deformation) of the capacitor in repeated use between high and low temperatures.

Next, the molten resin composition is extruded into a sheet using a T-die, and cooled and solidified by at least one metal drum to form an unstretched cast sheet. The surface temperature of the metal drum (the temperature of the metal drum with which the extruded sheet first comes into contact) is preferably 50°C or higher and 105°C or lower, and more preferably 60°C or higher and 100°C or lower. The surface temperature of the metal drum can be determined depending on the physical properties etc. of the polypropylene resin used. If the surface temperature of the metal drum is significantly lower than 50°C, the cast sheet is less likely to achieve good sheet moldability, which makes it difficult to obtain a polypropylene film well without stretching unevenness or breakage during stretching film formation.

The thickness of the cast sheet is not particularly limited, as long as the polypropylene film can be obtained. In general, the thickness of the cast sheet is preferably 0.05 mm or more and 2 mm or less, and more preferably 0.1 mm or more and 1 mm or less.

The polypropylene film can be produced by stretching the polypropylene cast sheet. Stretching is preferably biaxial stretching that causes orientation along longitudinal and lateral axes. The stretching method is preferably a sequential biaxial stretching method. In the sequential biaxial stretching method, for example, the cast sheet is first maintained at a temperature of 110°C or higher and 170°C or lower (preferably 135°C or higher and 170°C or lower), and stretched in the machine direction by passing the sheet between rolls having different speeds. The stretching ratio in the machine direction is preferably 3.5 times or more and 5.5 times or less, and more preferably 4.2 times or more and 5.4 times or less. Subsequently, the sheet is guided to a tenter and stretched in the transverse direction. The temperature during stretching in the transverse direction is preferably 150°C or higher and 165°C or lower, and the stretching ratio in the transverse direction is preferably 9 times or more and 11 times or less. Then, the film is relaxed at a factor of 2 or more and 10 or less and solidified by heat. The above process produces a biaxially stretched polypropylene film.

The thickness of the polypropylene film is preferably 0.8 µm or more and 6.0 µm or less, as described above, in terms of ensuring, when used in a capacitor, the smaller size and higher capacitance of the capacitor. Specifically, the thickness of the polypropylene film is preferably 5.5 um or less, more preferably 3.5 um or less, even more preferably 3.0 µm or less, and particularly preferably 2.4 um or less. Further, the thickness of the polypropylene film is preferably 1.0 um or more, more preferably 1.8 µm or more, and even more preferably 2.2 µm or more, in terms of production.

The polypropylene film may be subjected to corona discharge treatment online or offline after completion of the stretching and thermal solidification step, for the purpose of enhancing adhesive properties in a subsequent step, such as a metal deposition processing step. Corona discharge treatment can be performed by a known method. The treatment is preferably performed in an atmospheric gas, such as air, carbon dioxide gas, nitrogen gas, or a mixed gas thereof.

In the polypropylene film of the present invention obtained in the above manner, even when the film thickness is as thin as 6.0 µm or less, the film has excellent dielectric breakdown strength when a direct voltage is applied at a high temperature of about 120°C (100°C to 120°C), and excellent dielectric breakdown strength when an alternating voltage is applied, and also has excellent heat shrinkage resistance in terms of suppressing heat shrinkage in the machine direction (MD) at temperatures up to about 150°C exceeding the above high temperature. Further, the film capacitor of the present invention, which uses the polypropylene film as a capacitor derivative, has excellent heat resistance at a high temperature of about 120°C (100°C to 120°C) . Specifically, the film capacitor of the present invention has excellent lifetime performance in terms of suppressing the decrease in the capacitance of the capacitor even after use for a long period of time at the above high temperature, and has excellent heat shock resistance in terms of suppressing heat tightening (deformation) of the capacitor in repeated use between the above high temperature, assuming inside the engine room, and a low temperature. Therefore, the polypropylene film of the present invention is preferably for use in film capacitors, and can be preferably used as a capacitor derivative that constitutes an inverter in a hybrid car or an electric car.

### Metal Layer-Integrated Polypropylene Film, Film Capacitor, and Their Production Methods

The polypropylene film of the present invention may be formed as a metal layer-integrated polypropylene film having the polypropylene film and a metal layer laminated on one or both sides of the polypropylene film, in consideration of processing to capacitors.

The metal layer functions as an electrode. Examples of the metal used in the metal layer include single metals, such as zinc, lead, silver, chromium, aluminum, copper, and nickel; mixtures of several kinds of these metals; alloys thereof; and the like. In consideration of the environment, economical efficiency, capacitor performance, etc., zinc and aluminum are preferable.

Examples of the method for laminating a metal layer on one or both sides the polypropylene film include vacuum deposition and sputtering. Vacuum deposition is preferable, in terms of productivity, economical efficiency, etc. General examples of vacuum deposition include a crucible method, a wire method, and the like; however, the method is not particularly limited. An optimal method can be suitably selected.

The margin pattern when laminating a metal layer by deposition is not particularly limited. In terms of improving capacitor properties, such as fail-safe ability, it is preferable that a pattern containing a so-called special margin, such as a fishnet pattern and/or a T-margin pattern, is applied to one surface of the polypropylene film. The fail-safe ability is enhanced, and it is effective in terms of preventing the breakage and short-circuit of the capacitor.

The method for forming a margin can be a commonly known method, such as a tape method or an oil method, which can be used with no restrictions.

Further, the metal layer-integrated polypropylene film of the present invention can be laminated or wound by a conventionally known method to form a film capacitor.

That is, the film capacitor may have a structure in which a plurality of the metal layer-integrated polypropylene films are laminated, or may have the wound metal layer-integrated polypropylene film. Such film capacitors can be suitably used as capacitors for inverter power supplies that control drive motors of electric cars, hybrid cars, etc. In addition, the film capacitors can also be suitably used for railroad vehicles, wind power generation, solar power generation, and general household appliances.

### Examples

The present invention is described in more detail below while showing Examples and Comparative Examples. However, the present invention is not limited to the Examples.

### Resins

The details of the resins used in the Examples and Comparative Examples (PP resins A1 to A6 and PP resins B1 to B8) are summarized in the following Table 1, and the method for measuring each physical property is described below.

**Table 1**

| Name | Mn | Mw | Mz | Mw/Mn | Mz/Mn | Value using differential molecular weight distribution | | | Weight fraction w | HI | MFR |
|---|---|---|---|---|---|---|---|---|---|---|---|
| | × 10000 | × 10000 | × 10000 | | | Log(M) = 4.5 | Log(M) = 6.0 | DM "4.5" - "6.0" | % | % | g/10 min |
| PP resin A1 | 4.7 | 28 | 75 | 6.0 | 16.0 | 29.9 | 21.4 | 8.6 | 4.1 | 97.8 | 5.5 |
| PP resin A2 | 3.3 | 31 | 140 | 9.4 | 42.4 | 33.5 | 24.5 | 9.0 | 6.4 | 97.3 | 4.9 |
| PP resin A3 | 3.4 | 34 | 155 | 10.0 | 45.5 | 35.0 | 24.8 | 10.2 | 6.2 | 97.3 | 4.5 |
| PP resin A4 | 3.6 | 31 | 120 | 8.6 | 33.3 | 34.0 | 23.0 | 11.0 | 6.0 | 97.2 | 4.6 |
| PP resin A5 | 4.7 | 27 | 75 | 5.7 | 16.0 | 30.2 | 21.2 | 10.0 | 4.3 | 97.7 | 5.6 |
| PP resin A6 | 4.7 | 27 | 75 | 5.7 | 16.0 | 30.0 | 21.2 | 8.8 | 4.3 | 97.8 | 5.5 |
| PP resin B1 | 4.6 | 39 | 160 | 8.5 | 34.8 | 27.3 | 30.9 | -3.6 | 3.7 | 98.8 | 2.1 |
| PP resin B2 | 4.2 | 34 | 150 | 8.1 | 35.7 | 31.4 | 26.6 | 4.8 | 4.5 | 98.5 | 4.0 |
| PP resin B3 | 7.6 | 46 | 190 | 6.1 | 25.0 | 20.8 | 37.1 | -16.3 | 1.9 | 98.9 | 0.7 |
| PP resin B4 | 4.2 | 32 | 120 | 7.6 | 28.6 | 32.0 | 25.4 | 6.6 | 4.6 | 98.5 | 3.0 |
| PP resin B5 | 4.4 | 35 | 150 | 8.0 | 34.8 | 32.3 | 25.3 | 7.0 | 4.6 | 98.6 | 3.0 |
| PP resin B6 | 4.5 | 34 | 130 | 7.6 | 28.9 | 31.3 | 27.7 | 3.6 | 4.5 | 98.6 | 3.1 |
| PP resin B7 | 4.6 | 38 | 160 | 8.3 | 34.8 | 27.4 | 30.8 | -3.4 | 3.8 | 98.7 | 2.3 |
| PP resin B8 | 4.6 | 38 | 160 | 8.3 | 34.8 | 27.4 | 30.8 | -3.4 | 3.8 | 98.8 | 2.1 |

| | | | | | | | | | | | |
|---|---|---|---|---|---|---|---|---|---|---|---|
| PP resins A1 to A6: produced by Prime Polymer Co., Ltd. PP resin B1: S802M Type A, produced by Korea Petro Chemical Ind. Co., Ltd. PP resin B2: HC300BF, produced by Borealis PP resin B3: S800, produced by Korea Petro Chemical Ind. Co., Ltd. PP resin B4: HU300, produced by Samsung Total Petrochemicals Co., Ltd. PP resin B5: HPT-1 Type A, produced by Korea Petro Chemical Ind. Co., Ltd. PP resin B6: HPT-1 Type B, produced by Korea Petro Chemical Ind. Co., Ltd. PP resin B7: S802M Type B, produced by Korea Petro Chemical Ind. Co., Ltd. PP resin B8: S802M Type C, produced by Korea Petro Chemical Ind. Co., Ltd. | | | | | | | | | | | |

### Measurement of Number Average Molecular Weight (Mn), Weight Average Molecular weight (Mw), Z-Average Molecular Weight (Mz), Molecular Weight Distribution (Mw/Mn), Molecular Weight Distribution (Mz/Mn), and Weight Fraction W of Polypropylene Resins

First, the average molecular weight and molecular weight distribution of each polypropylene resin were measured by size exclusion chromatography (SEC) under the following conditions.
Device: HLC-8321GPC/HT (detector: differential refractometer (RI)) (produced by Tosoh Corporation)
Columns: one TSKgel guardcolumn HHR(30)HT column (7.5 mm I.D. × 7.5 cm) + three TSKgel GMHHR-H(20)HT columns (7.8 mm I.D. × 30 cm) (produced by Tosoh Corporation)
Eluent: 1,2,4-trichlorobenzene (for GPC, produced by FUJIFILM Wako Pure Chemical Corporation) + BHT (0.05%)
Flow rate: 1.0 mL/min
Detection condition: polarity-(-)
Injected amount: 0.3 mL
Column temperature: 140°C
System temperature: 40°C
Sample concentration: 1 mg/mL
Sample pretreatment: A sample was weighed, a solvent (1,2,4-trichlorobenzene containing 0.1% BHT) was added, and the sample was dissolved by shaking at 140°C for 1 hour. Then, the resultant was heated and filtered through a 0.5-um sintered filter. Calibration curve: A calibration curve of the fifth-order approximate curve was prepared using polystyrene standard produced by Tosoh Corporation. However, the molecular weight was converted into the molecular weight of polypropylene using the Q-factor.

From the obtained calibration curve and SEC chromatogram, analysis software for the measurement device was used to plot the molecular weight (logarithmic values) on the horizontal axis and the integral value of the concentration fraction on the vertical axis, thereby obtaining an integral molecular weight distribution curve. The derivative value (slope of the integral molecular weight distribution curve) of the integral molecular weight distribution curve at each molecular weight was determined, and a derivative molecular weight distribution curve was obtained by plotting the molecular weight (log values) on the horizontal axis and the derivative values on the vertical axis.

The number average molecular weight Mn, weight average molecular weight Mw, and Z-average molecular weight Mz were obtained from these curves. The Mw and Mn values were used to obtain a molecular weight distribution (Mw/Mn). Further, in the integral molecular weight distribution curve, the value when the logarithmic molecular weight Log(M) = 4.0 was defined as weight fraction w. The weight fraction w indicates the weight fraction of a molecule at a logarithmic molecular weight Log(M) of 4.0, i.e., a molecular weight of 10,000 or less.

### Measurement of Differential Molecular Weight Distribution Value When Logarithmic Molecular Weight Log(M) = 4.5, Differential Molecular Weight Distribution Value When Logarithmic Molecular Weight Log(M) = 6.0, and Difference in Differential Molecular Weight Distribution (D_{M})

For each polypropylene resin, the differential molecular weight distribution value when the logarithmic molecular weight Log(M) = 4.5 and the differential molecular weight distribution value when the logarithmic molecular weight Log(M) = 6.0 were obtained in the following manner. First, a time curve (elution curve) of intensity distribution detected by an RI detector was converted into a distribution curve with respect to the molecular weight M (Log(M)) of the above polystyrene standard using the calibration curve produced using the polystyrene standard. Next, after an integral distribution curve with respect to Log(M) when the total area of the distribution curve was regarded as 100% was obtained, the integral distribution curve was differentiated by Log(M) to thereby obtain a differential distribution curve with respect to Log(M). Differential molecular weight distribution values when Log(M) = 4.5 and when Log(M) = 6.0 were read from this differential distribution curve. The difference between the differential molecular weight distribution value when Log(M) = 4.5 and the differential molecular weight distribution value when Log(M) = 6.0 was defined as the difference in differential molecular weight distribution (D_{M}). The series of operations until the differential distribution curve was obtained was carried out using analysis software provided in the GPC measurement apparatus.

### Measurement of Heptane Insoluble (HI)

Each polypropylene resin was press-molded to 10 mm × 35 mm × 0.3 mm to prepare about 3 g of a measurement sample. Next, about 150 mL of heptane was added, and Soxhlet extraction was performed for 8 hours. The heptane insoluble was calculated from the sample mass before and after extraction.

### Measurement of Melt Flow Rate (MFR)

The melt flow rate (MFR) in the form of the raw material resin pellets used in the Examples and Comparative Examples was measured by the melt index of Toyo Seiki Co., Ltd. according to the condition M of JIS K 7210. Specifically, first, a sample weighed to 4 g was inserted into a cylinder at a test temperature of 230°C, and preheated under a load of 2.16 kg for 3.5 minutes. Then, the weight of the sample extruded from the bottom hole for 30 seconds was measured, and MFR (unit: g/10 min) was determined. The above measurements were repeated 3 times, and the average value was taken as the measured value of MFR.

### Examples 1 to 14 and Comparative Examples 1 to 18

### Production of Biaxially Stretched Polypropylene Films and Evaluation of Their Characteristics

Polypropylene resins A and B were weighed according to Table 2 and mixed at the weight ratios shown in Table 2 to obtain dry-blended resin compositions. Next, each dry-blended resin composition was supplied to an extruder and melted at the melting temperature and shear rate shown in Table 2. This molten resin was extruded using a T-die, wound around a metal drum whose surface temperature was maintained at 95°C, and solidified to produce a cast sheet. The unstretched cast sheet was maintained at a temperature of 140°C, passed between rolls having different speeds, stretched by a factor of 4.5 in the machine direction, and immediately cooled to room temperature. Subsequently, the stretched film obtained by stretching in the machine direction was guided to a tenter and stretched by a factor of 10 in the traverse direction at a traverse stretching temperature of 158°C. After relaxation at a relaxation rate of 12% and thermal solidification, the biaxially stretched polypropylene film with a width of about 5 m and a thickness of 2.3 µm was wound around an iron core with a diameter of 400 mm by about 80,000 m under the atmosphere shown in Table 2 and wound as a large roll. The wound biaxially stretched polypropylene film was treated in an atmosphere of 35°C for 24 hours for aging treatment.

**Table 2-1**

| | Raw material | | | | Production conditions | | | |
|---|---|---|---|---|---|---|---|---|
| | Base resin | Number of parts | Blend resin | Number of parts | Melting temperature | Shear rate | Atmospheric temperature of winder | Temperature of aging yard (24-hour treatment) |
| | | Parts | | Parts | °C | s⁻¹ | | |
| Ex 1 | Resin A1 | 75 | Resin B1 | 25 | 250 | 2000 | 35°C | 35°C |
| Ex 2 | Resin A1 | 65 | Resin B1 | 35 | 250 | 2000 | 35°C | 35°C |
| Ex 3 | Resin A1 | 55 | Resin B1 | 45 | 250 | 2000 | 35°C | 35°C |
| Ex 4 | Resin A1 | 75 | Resin B2 | 25 | 250 | 2000 | 35°C | 35°C |
| Ex 5 | Resin A1 | 65 | Resin B2 | 35 | 250 | 2000 | 35°C | 35°C |
| Ex 6 | Resin A1 | 75 | Resin B2 | 25 | 270 | 2000 | 35°C | 35°C |
| Ex 7 | Resin A1 | 65 | Resin B2 | 35 | 230 | 2000 | 35°C | 35°C |
| Ex 8 | Resin A1 | 65 | Resin B2 | 35 | 270 | 10000 | 35°C | 35°C |
| Ex 9 | Resin A1 | 55 | Resin B1 | 45 | 250 | 2000 | 25°C | 35°C |
| Ex 10 | Resin A1 | 51 | Resin B3 | 49 | 245 | 2300 | 40°C | 35°C |
| Ex 11 | Resin A1 | 75 | Resin B1 | 25 | 260 | 5000 | 35°C | 35°C |
| Ex 12 | Resin A1 | 75 | Resin B1 | 25 | 240 | 4000 | 35°C | 35°C |
| Ex 13 | Resin A1 | 65 | Resin B1 | 35 | 240 | 4000 | 35°C | 35°C |
| Ex 14 | Resin A1 | 55 | Resin B1 | 45 | 240 | 4000 | 35°C | 35°C |
| | | | | | | | | |
| Com Ex 1 | Resin A1 | 95 | Resin B1 | 5 | 250 | 2000 | 35°C | 35°C |
| Com Ex 2 | Resin A1 | 45 | Resin B1 | 55 | 250 | 2000 | 35°C | 35°C |
| Com Ex 3 | Resin A1 | 30 | Resin B1 | 70 | 250 | 2000 | 35°C | 35°C |
| Com Ex 4 | Resin A2 | 65 | Resin B3 | 35 | 250 | 2000 | 35°C | 35°C |
| Com Ex 5 | Resin A2 | 65 | Resin B1 | 35 | 250 | 2000 | 35°C | 35°C |
| Com Ex 6 | - | - | Resin B4 | 100 | 250 | 2000 | 35°C | 35°C |
| Com Ex 7 | Resin A1 | 92 | Resin B1 | 8 | 280 | 2000 | 35°C | 35°C |
| Com Ex 8 | Resin A1 | 5 | Resin B3 | 95 | 280 | 16000 | 35°C | 35°C |
| Com Ex 9 | Resin A1 | 65 | Resin B2 | 35 | 290 | 10000 | 35°C | 35°C |
| Com Ex 10 | Resin A1 | 65 | Resin B2 | 35 | 220 | 2000 | 35°C | 35°C |
| Com Ex 11 | Resin A1 | 55 | Resin B1 | 45 | 250 | 2000 | 15°C | 35°C |
| Com Ex 12 | Resin A1 | 55 | Resin B1 | 45 | 250 | 2000 | 47°C | 35°C |
| Com Ex 13 | Resin A3 | 65 | Resin B5 | 35 | 250 | 2000 | 25°C | 35°C |
| Com Ex 14 | Resin A4 | 65 | Resin B6 | 35 | 250 | 2000 | 25°C | 35°C |
| Com Ex 15 | Resin A5 | 75 | Resin B7 | 25 | 250 | 1800 | 30°C | 35°C |
| Com Ex 16 | Resin A6 | 75 | Resin B8 | 25 | 260 | 1800 | 23°C | 35°C |
| Com Ex 17 | Resin A1 | 45 | Resin B1 | 55 | 250 | 3000 | 35°C | 35°C |
| Com Ex 18 | - | - | Resin B5 | 100 | 250 | 4000 | 35°C | 35°C |

**Table 2-2**

| | Film physical properties | | | | | | | | | | Large roll | Element physical properties | | | |
|---|---|---|---|---|---|---|---|---|---|---|---|---|---|---|---|
| | Thickness | Mz × 10000 | Mw/Mn | Weight fraction w | Density | ACES 100°C | ACES 110°C | ACES 120°C | DCES 120°C | TMA | Winding quality (wrinkles) during aging | Lifetime | Heat shock | Deposition processability | Element-winding processability |
| | µm | | | % | g/cm3 | V/µm | V/µm | V/µm | V/µm | | | | | | |
| Ex1 | 2.3 | 72 | 6.3 | 3.6 | 921 | 251 | 244 | 238 | 527 | A | AA | A | A | A | A |
| Ex2 | 2.3 | 79 | 6.6 | 3.6 | 921 | 253 | 246 | 240 | 532 | A | AA | A | A | A | A |
| Ex3 | 2.3 | 85 | 6.8 | 3.6 | 921 | 248 | 241 | 235 | 521 | A | A | A | A | A | A |
| Ex4 | 2.3 | 92 | 6.3 | 4.1 | 919 | 243 | 240 | 236 | 524 | A | A | A | A | A | A |
| Ex 5 | 2.3 | 93 | 6.5 | 4.2 | 919 | 245 | 242 | 237 | 527 | A | A | A | A | A | A |
| Ex 6 | 2.3 | 92 | 6.6 | 4.2 | 919 | 243 | 240 | 235 | 522 | A | A | A | A | A | A |
| Ex 7 | 2.3 | 94 | 6.5 | 4.1 | 919 | 245 | 243 | 237 | 529 | A | A | A | A | A | A |
| Ex8 | 2.3 | 92 | 6.5 | 4.2 | 919 | 244 | 240 | 236 | 525 | A | A | A | A | A | A |
| Ex 9 | 2.3 | 85 | 6.8 | 3.6 | 921 | 248 | 241 | 235 | 521 | A | A | A | A | A | A |
| Ex 10 | 2.3 | 94.5 | 6.7 | 2.8 | 922 | 255 | 246 | 240 | 536 | A | A | A | B | A | A |
| Ex 11 | 2.3 | 72 | 5.2 | 3.6 | 921 | 250 | 243 | 238 | 526 | A | AA | A | A | A | A |
| Ex 12 | 6.0 | 83 | 5.6 | 3.5 | 920 | 254 | 248 | 242 | 531 | A | AA | A | A | A | A |
| Ex 13 | 6.0 | 85 | 5.8 | 3.4 | 921 | 258 | 250 | 245 | 538 | A | AA | A | A | A | A |
| Ex 14 | 6.0 | 88 | 5.9 | 3.2 | 921 | 252 | 244 | 238 | 526 | A | A | A | A | A | A |
| | | | | | | | | | | | | | | | |
| Com Ex 1 | 2.3 | 67 | 6.1 | 4.3 | 920 | 245 | 238 | 232 | 515 | A | AA | B | A | A | A |
| Com Ex 2 | 2.3 | 92 | 7.0 | 3.5 | 921 | 244 | 237 | 231 | 512 | C | B | B | C | A | A |
| Com Ex 3 | 2.3 | 95 | 7.4 | 3.5 | 921 | 243 | 236 | 231 | 511 | C | C | B | C | A | A |
| Com Ex4 | 2.3 | 120 | 8.7 | 4.2 | 922 | 245 | 235 | 225 | 491 | C | C | A | C | A | A |
| Com Ex 5 | 2.3 | 100 | 6.7 | 4.9 | 919 | 256 | 249 | 239 | 530 | C | C | A | C | A | A |
| Com Ex 6 | 2.3 | 118 | 7.6 | 4.6 | 913 | 233 | 224 | 220 | 503 | C | C | C | C | A | A |
| Com Ex 7 | 2.3 | 64 | 6.1 | 4.2 | 919 | 244 | 238 | 230 | 510 | A | AA | C | A | A | A |
| Com Ex8 | Unstretchable | 94 | 6.5 | 2.5 | - | - | - | - | - | - | - | - | - | - | - |
| Com Ex9 | 2.3 | 92 | 6.5 | 4.4 | 919 | 243 | 239 | 234 | 522 | A | A | B | A | A | A |
| Com Ex 10 | 2.3 | 96 | 6.4 | 4.1 | 919 | 245 | 242 | 239 | 530 | C | A | A | C | A | A |
| Com Ex 11 | 2.3 | 85 | 6.8 | 3.6 | 921 | 247 | 240 | 235 | 520 | C | B | A | C | A | A |
| Com Ex 12 | 2.3 | 85 | 6.8 | 3.6 | - | - | - | - | - | C | C (blocking) | - | - | - | - |
| Com Ex 13 | 2.3 | 101 | 7.8 | 5.9 | 919 | 250 | 241 | 232 | 521 | C | C | B | C | A | A |
| Com Ex 14 | 2.3 | 98 | 7.3 | 6.0 | 919 | 248 | 240 | 231 | 518 | C | C | B | C | A | A |
| Com Ex 15 | 2.3 | 70 | 6.4 | 4.3 | 920 | 246 | 242 | 238 | 516 | A | AA | B | A | A | A |
| Com Ex 16 | 2.3 | 70 | 6.4 | 4.3 | 920 | 247 | 240 | 238 | 515 | A | AA | B | A | A | A |
| Com Ex 17 | 6.0 | 93 | 7.0 | 3.4 | 921 | 244 | 238 | 233 | 515 | C | B | B | C | A | A |
| Com Ex 18 | 6.0 | 120 | 6.9 | 4.0 | 919 | 248 | 240 | 233 | 514 | C | C | C | C | A | A |

The methods for measuring the thickness, density, and dielectric breakdown strength of the biaxially stretched polypropylene films obtained in the Examples and Comparative Examples, the method for performing thermomechanical analysis (TMA), and the method for evaluating the winding quality (wrinkles) of the large rolls during aging are shown below. Table 2 also shows the results of each measurement and evaluation.

### Measurement of Polypropylene Film Thickness

A paper thickness measuring instrument (MEI-11, produced by Citizen Seimitsu Co., Ltd.; measurement pressure: 100 kPa, descent speed: 3 mm/sec, measuring terminal ϕ = 16 mm, measuring force: 20.1 N) was used in the environment of temperature 23 ± 2°C and humidity 50 ± 5% RH. 10 or more stacked samples were cut out from the roll, and handled so that wrinkles or air did not enter the film during cutting. The thickness of the 10 stacked samples was measured 5 times, and the average value of the 5 measurements was divided by 10 to calculate the thickness.

### Measurement of Polypropylene Film Density

The density of the polypropylene films was measured according to the method D of JIS K7112 (1999).
Measurement device: Density gradient tube-type specific gravity measuring device, Type A, produced by Shibayama Scientific Co., Ltd.
Gradient liquid: ethanol aqueous solution
Measurement temperature: 23 ± 0.5°C
Number of measurements: n = 3

### Measurement of Dielectric Breakdown Strength of Polypropylene Films: Direct Current (DC)

The dielectric breakdown voltage (BDV) of the polypropylene films according to the Examples and Comparative Examples was measured 16 times under the following test conditions with the electrode configuration described in JIS C 2151 (2006) 17.2.2 (plate electrode method). The applied voltage at the time when the leakage current of the following upper limit reference value was detected during the pressure rise was defined as BDV. BDV was divided by the film thickness (µm), and the average value of 12 points excluding the upper 2 points and the lower 2 points in the 16 measurement results was taken as the dielectric breakdown strength ES (VDC/um).
Specimen: about 150 mm × 150 mm
Specimen condition adjustment: 30 minutes under atmospheric conditions
Power source: direct current
Atmosphere: in the air, 120°C
Tester: DC Withstanding Voltage/Insulation Resistance Tester TOS9213AS, produced by Kikusui Electronics Corp.
Voltage rise rate: 100 V/s
Current detection response speed: MID
Upper limit reference value: 5 mA

### Measurement of Dielectric Breakdown Strength of Polypropylene Films: Alternate Current (AC)

The dielectric breakdown voltage (BDV) of the films according to the Examples and Comparative Examples was measured 12 times under the following test conditions with the electrode configuration described in JIS C 2151 (2006) 17.2.2 (plate electrode method). The applied voltage at the time when the leakage current of the following upper limit reference value was detected during the pressure rise was defined as BDV. BDV was divided by the film thickness (pm), and the average value of 8 points excluding the upper 2 points and the lower 2 points in the 12 measurement results was taken as the dielectric breakdown strength ES (VAC/um).
Specimen: about 150 mm × 150 mm
Specimen condition adjustment: 30 minutes under atmospheric conditions
Power source: alternate current
Atmosphere: in the air, 100°C, 110°C, 120°C
Tester: Withstanding Voltage Tester TOS5051A, produced by Kikusui Electronics Corp.
Voltage rise rate: 100 V/s
Upper limit reference value: 5 mA

### Thermomechanical Analysis (TMA)

The thermomechanical analysis was performed as described below.
Device: EXSTAR6000 and TMA/SS6000, produced by Seiko Instruments Inc.
Film width: 4 mm
Distance between chucks: 15 mm
Load: 2.17 N/mm²
Measurement temperature region: 25°C to 155°C
Heating rate: 10°C/min

A TMA curve was drawn with the temperature on the horizontal axis and the dimensional change of the film in the machine direction (MD) on the vertical axis. A dimensional change of 0% or more in the heating process from 25°C to 155°C was regarded as acceptable "A," and less than 0% as rejected "C."

### Winding Quality (Wrinkles) of Large Rolls after Aging

The appearance of the large rolls excluding about 100 mm at both ends after aging was evaluated in terms of winding quality (wrinkles). The following defect line (vertical defect line) is a defect in the winding shape, such as a ribbed metal can, that occurs in parallel with the circumferential direction, which is generally called an MD line or a can shape.

No defect line (vertical defect line) in the circumferential direction with a depth of 0.5 mm or more was regarded as excellent "AA," only one defect line (vertical defect line) in the circumferential direction with a depth of 0.5 mm or more as good "A," two or three defect lines (vertical defect lines) in the circumferential direction with a depth of 0.5 mm or more as normal "B," and four or more defect lines (vertical defect lines) in the circumferential direction with a depth of 0.5 mm or more as bad "C." In the case of excellent "AA," it can be said that even if there are defect lines (vertical defect lines) in the circumferential direction, the depth is less than 0.5 mm, and they are present almost evenly in the width direction. Excellent "AA" and good "A" are acceptable (acceptable range), and normal "B" and bad "C" are rejected.

### Production of Film Capacitors and Evaluation of Their Characteristics

The biaxially stretched polypropylene films obtained in the Examples and Comparative Examples were used to produce film capacitors in the following manner.

A special deposition pattern margin and an insulation margin for imparting film capacitor fail-safe ability were formed on each biaxially stretched polypropylene film, and aluminum deposition was applied so that the metal film had a surface resistivity of 20 Q/D, thereby obtaining a metal layer-integrated polypropylene film. After the metal layer-integrated polypropylene film was silt to an arbitrary width, the two metal layer-integrated polypropylene films were combined and wound using a 3KAW-N2 automatic winder (produced by Kaido Mfg. Co., Ltd.) at a winding speed of 4 m/sec, a winding tension of 180 g, and a contact roller contact pressure of 260 g while setting the number of turns so that the element capacitance was 50 µF.

After the element-wound element was pressed and flattened, zinc metal was sprayed on the element end surface to form an electrode extraction portion while the press load was applied, followed by heat treatment at 120°C for 15 hours for thermal curing.

After thermal curing, leads were soldered to the element end surface and sealed with epoxy resin to obtain a flat film capacitor. The capacitance of all of the obtained film capacitors was 50 µF (± 3 µF).

The methods for evaluating deposition processability and element-winding processability in the production process of the film capacitors obtained in the Examples and Comparative Examples, and the methods for evaluating the lifetime characteristics and heat shock resistance of the film capacitors are shown below. Table 2 also shows the results of each evaluation.

### Deposition Processability

A wrinkle formation rate of less than 5% due to thermal deformation in the film after deposition was regarded as "A," and 5% or more as "C."

### Evaluation of Element-Winding Processability

Of the small rolls obtained by deposition and slitting, a left-margin winding reel and a right-margin winding reel were used to wind two superimposed films so that the deposition portions protruded beyond the margin portions in the width direction (element-winding process). The winding was performed for 1360 turns at a winding tension of 200 g using a 3KAW-N2 automatic winder (produced by Kaido Mfg. Co., Ltd.). At that time, the films were visually observed from the start to the end of winding. Those with wrinkles or misalignment were rejected, and the ratio of the number of rejected products to the total number of products produced was expressed as a percentage and used as an index of processability (hereinafter referred to as "element-winding yield"). A higher element-winding yield is more preferable. An element-winding yield of 95% or more was regarded as good "A," and less than 95% as bad "C."

### Lifetime Characteristics (Capacitance Change)

The initial capacitance of the obtained capacitor before the test was evaluated by an LCR Hi-Tester 3522-50 (produced by Hioki E.E. Corp.). Next, a direct voltage of 800 V (348 V/µm) was continuously applied to the capacitor in a high-temperature chamber at 115°C for 500 hours. The capacitance of the capacitor after 500 hours was measured in the same manner, and the capacitance change before and after voltage application was calculated by the following formula. The test was conducted using 2 samples, and their average value was used for evaluation. (Capacitance change) = [(capacitance after voltage application) - (initial capacitance)]/(initial capacitance) × 100 (%)

A capacitance change within -4% after 500 hours was regarded as good "A," more than -4% and -6% or less as "B," and more than -6% as bad "C."

### Heat Shock Resistance (Tanδ Change)

The obtained capacitor was placed in a thermal shock chamber (Espec TSA-101S-W), and a rapid heating-cooling cycle was repeated 500 times between the lower limit temperature of -40°C and the upper limit temperature of 105°C. Specifically, holding at -40°C for 50 minutes and holding at 105°C for 50 minutes were repeated 500 times as one set. The temperature was forcedly switched by blowing air at the set temperature. The temperature switching time was also included in the 50-minute holding time.

Tanδ before and after the heat shock test was measured by an LCR Hi-Tester 3522-50 (produced by Hioki E.E. Corp.). The rate of increase in tanδ was calculated by the following formula. (Rate of increase in tanδ) = [(tanδ after heat shock test) - (tanδ before heat shock test)]/(tanδ before heat shock test) × 100 (%)

The test was conducted using 3 samples, and their average value was used for evaluation.

A rate of increase of 100% or less was regarded as good "A," more than 100% and 105% or less as "B," and more than 105% as bad "C."

### Consideration

In the polypropylene films of the present invention produced in Examples 1 to 14, the polypropylene resin constituting the film has specific ranges of a molecular weight distribution (Mw/Mn) of weight average molecular weight Mw to number average molecular weight Mn, a Z-average molecular weight Mz, and a weight fraction w when the logarithmic molecular weight Log(M) - 4.0 in an integral molecular weight distribution curve, whereby even when the film thickness is as thin as 6.0 µm or less, the film has excellent dielectric breakdown strength when a direct voltage is applied at a high temperature of about 120°C (100°C to 120°C) , and excellent dielectric breakdown strength when an alternating voltage is applied, and also has excellent heat shrinkage resistance in terms of suppressing heat shrinkage in the machine direction (MD) at temperatures up to about 150°C exceeding the above high temperature. Further, the film capacitors produced in the Examples have excellent heat resistance at a high temperature of about 120°C (100°C to 120°C) . Specifically, the film capacitor of the present invention has excellent lifetime performance in terms of suppressing the decrease in the capacitance of the capacitor even after use for a long period of time at the above high temperature, and has excellent heat shock resistance in terms of suppressing heat tightening (deformation) of the capacitor in repeated use between the above high temperature, assuming inside the engine room, and a low temperature. In addition, according to the polypropylene film of the present invention, good evaluation results were obtained in terms of the appearance of the large roll after aging (winding quality (wrinkles)), and deposition processability and element-winding processability during capacitor production.

## Claims

1. A polypropylene film, a polypropylene resin constituting the polypropylene film having:
- a molecular weight distribution (Mw/Mn) of weight average molecular weight Mw to number average molecular weight Mn of 5.0 or more and 6.9 or less;
- a Z-average molecular weight Mz of 650,000 or more and 945,000 or less; and
- a weight fraction w of 2.6% or more and 4.2% or less when the logarithmic molecular weight Log(M) - 4.0 in an integral molecular weight distribution curve.

2. The polypropylene film according to claim 1, for use in a capacitor.

3. The polypropylene film according to claim 1 or 2, which is a biaxially stretched film.

4. The polypropylene film according to any one of claims 1 to 3, wherein in thermomechanical analysis, when heating is performed from 25°C to 155°C at a rate of 10°C/min under a load of 2.17 N/mm², and a TMA curve is drawn with the temperature on the horizontal axis and the dimensional change of the film in the machine direction (MD) on the vertical axis, the dimensional change is 0% or more in the heating process from 25°C to 155°C.

5. The polypropylene film according to any one of claims 1 to 4, wherein the difference (V_{DC120°C}-V_{AC120°C}) between dielectric breakdown strength at direct voltage at 120°C (V_{DC120°C}) and dielectric breakdown strength at alternating voltage at 120°C (V_{AC120°C}) is 280 V/µm or more and 300 V/um or less.

6. The polypropylene film according to any one of claims 1 to 5, wherein the Mz is more than 700,000.

7. The polypropylene film according to any one of claims 1 to 6, wherein:
- the molecular weight distribution (Mw/Mn) is 5.0 or more and 6.6 or less;
- the Mz is 720,000 or more and 790,000 or less; and
- the weight fraction w is 3.5% or more and 3.7% or less.

8. The polypropylene film according to any one of claims 1 to 7, wherein the polypropylene resin comprises polypropylene resins A and B, and the content of the polypropylene resin A in the polypropylene resin is larger than the content of the polypropylene resin B in the polypropylene resin;
- the polypropylene resin A has a Mw of 275,000 or more and less than 350,000;
- the polypropylene resin A has a molecular weight distribution (Mw/Mn) of 5.8 or more and 10.0 or less; and
- the polypropylene resin A has a melt flow rate (MFR_{A}) of 4.8 g/10 min or more and 5.5 g/10 min or less.

9. The polypropylene film according to any one of claims 1 to 8, wherein the polypropylene resin comprises polypropylene resins A and B, and the content of the polypropylene resin A in the polypropylene resin is larger than the content of the polypropylene resin B in the polypropylene resin;
- the polypropylene resin B has a Mw of 385,000 or more and 550,000 or less;
- the polypropylene resin B has a molecular weight distribution (Mw/Mn) of 8.4 or more and 11.0 or less; and
- the polypropylene resin B has a melt flow rate (MFR_{B}) of 0.1 g/10 min or more and 2.2 g/10 min or less.

10. The polypropylene film according to claim 8 or 9, wherein the ratio of the mass of the polypropylene resin A to the total mass of the polypropylene resins A and B is 65 to 75 mass%.

11. The polypropylene film according to any one of claims 1 to 10, wherein the polypropylene film has a thickness of 1.0 µm or more and 6.0 µm or less.

12. A metal layer-integrated polypropylene film having the polypropylene film according to any one of claims 1 to 11, and a metal layer laminated on one or both sides of the polypropylene film.

13. A film capacitor having the wound metal layer-integrated polypropylene film according to claim 12, or having a structure in which a plurality of the metal layer-integrated polypropylene films according to claim 12 are laminated.

## Patentansprüche

1. Polypropylenfolie, wobei ein Polypropylenharz, das die Polypropylenfolie ausmacht, aufweist:
- eine Molekulargewichtsverteilung (Mw/Mn) eines Molekulargewicht-Gewichtsmittels Mw zu einem Molekulargewicht-Zahlenmittel Mn von 5,0 oder mehr und 6,9 oder weniger;
- ein Z-gemitteltes Molekulargewicht Mz von 650.000 oder mehr und 945.000 oder weniger; und
- einen Gewichtsanteil w von 2,6% oder mehr und 4,2% oder weniger, wenn das logarithmische Molekulargewicht Log(M) = 4,0 in einer integralen Molekulargewichtsverteilungskurve ist.

2. Polypropylenfolie nach Anspruch 1 zur Verwendung in einem Kondensator.

3. Polypropylenfolie nach Anspruch 1 oder 2, welche eine biaxial gedehnte Folie ist.

4. Polypropylenfolie nach einem der Ansprüche 1 bis 3, wobei in einer thermomechanischen Analyse, wenn eine Erwärmung von 25°C auf 155°C mit einer Rate von 10°C/min unter einer Belastung von 2,17 N/mm² durchgeführt wird und eine TMA-Kurve mit der Temperatur auf der horizontalen Achse und der Dimensionsänderung der Folie in der Maschinenrichtung (MD) auf der vertikalen Achse gezeichnet wird, die Dimensionsänderung 0% oder mehr in dem Erwärmungsprozess von 25°C auf 155°C beträgt.

5. Polypropylenfolie nach einem der Ansprüche 1 bis 4, wobei die Differenz (V_{DC120°C}-V_{AC120°C}) zwischen einer dielektrischen Durchschlagsstärke bei Gleichspannung bei 120°C (V_{DC120°C}) und einer dielektrischen Durchschlagsstärke bei Wechselspannung bei 120°C (V_{AC120°C}) 280 V/µm oder mehr und 300 V/µm oder weniger beträgt.

6. Polypropylenfolie nach einem der Ansprüche 1 bis 5, wobei das Mz mehr als 700.000 beträgt.

7. Polypropylenfolie nach einem der Ansprüche 1 bis 6, wobei:
- die Molekulargewichtsverteilung (Mw/Mn) 5,0 oder mehr und 6,6 oder weniger beträgt;
- das Mz 720.000 oder mehr und 790.000 oder weniger beträgt; und
- der Gewichtsanteil w 3,5% oder mehr und 3,7% oder weniger beträgt.

8. Polypropylenfolie nach einem der Ansprüche 1 bis 7, wobei das Polypropylenharz die Polypropylenharze A und B umfasst und der Gehalt des Polypropylenharzes A in dem Polypropylenharz größer ist als der Gehalt des Polypropylenharzes B in dem Polypropylenharz;
- das Polypropylenharz A ein Mw von 275.000 oder mehr und weniger als 350.000 aufweist;
- das Polypropylenharz A eine Molekulargewichtsverteilung (Mw/Mn) von 5,8 oder mehr und 10,0 oder weniger aufweist; und
- das Polypropylenharz A eine Schmelzflussrate (MFR_{A}) von 4,8 g/10 min oder mehr und 5,5 g/10 min oder weniger aufweist.

9. Polypropylenfolie nach einem der Ansprüche 1 bis 8, wobei das Polypropylenharz die Polypropylenharze A und B umfasst und der Gehalt des Polypropylenharzes A in dem Polypropylenharz größer ist als der Gehalt des Polypropylenharzes B in dem Polypropylenharz;
- das Polypropylenharz B ein Mw von 385.000 oder mehr und 550.000 oder weniger aufweist;
- das Polypropylenharz B eine Molekulargewichtsverteilung (Mw/Mn) von 8,4 oder mehr und 11,0 oder weniger aufweist; und
- das Polypropylenharz B eine Schmelzflussrate (MFR_{B}) von 0,1 g/10 min oder mehr und 2,2 g/10 min oder weniger aufweist.

10. Polypropylenfolie nach Anspruch 8 oder 9, wobei das Verhältnis der Masse des Polypropylenharzes A zur Gesamtmasse der Polypropylenharze A und B 65 bis 75 Massen-% beträgt.

11. Polypropylenfolie nach einem der Ansprüche 1 bis 10, wobei die Polypropylenfolie eine Dicke von 1,0 µm oder mehr und 6,0 µm oder weniger aufweist.

12. Metallschicht-integrierte Polypropylenfolie mit der Polypropylenfolie nach einem der Ansprüche 1 bis 11 und einer auf eine oder beide Seiten der Polypropylenfolie laminierten Metallschicht.

13. Folienkondensator mit der gewickelten, Metallschicht-integrierten Polypropylenfolie nach Anspruch 12 oder mit einer Struktur, in welcher eine Mehrzahl der Metallschicht-integrierten Polypropylenfolien nach Anspruch 12 laminiert sind.

## Revendications

1. Film de polypropylène, une résine de polypropylène constituant le film de polypropylène ayant :
- une distribution de poids moléculaires (Mw/Mn) de poids moléculaire moyen en poids Mw sur poids moléculaire moyen en nombre Mn de 5,0 ou plus et 6,9 ou moins ;
- un poids moléculaire moyen en Z Mz de 650 000 ou plus et 945 000 ou moins ; et
- une fraction pondérale w de 2,6 % ou plus et 4,2 % ou moins lorsque le poids moléculaire logarithmique Log(M) = 4,0 dans une courbe de distribution de poids moléculaires intégrale.

2. Film de polypropylène selon la revendication 1, destiné à être utilisé dans un condensateur.

3. Film de polypropylène selon la revendication 1 ou 2, qui est un film étiré de manière biaxiale.

4. Film de polypropylène selon l'une quelconque des revendications 1 à 3, dans lequel en analyse thermomécanique, lorsqu'un chauffage est réalisé de 25 °C à 155 °C à un taux de 10 °C/min sous une charge de 2,17 N/mm², et une courbe TMA est dessinée avec la température sur l'axe horizontal et le changement dimensionnel du film dans la direction de machine (MD) sur l'axe vertical, le changement dimensionnel est de 0 % ou plus dans le processus de chauffage de 25 °C à 155 °C.

5. Film de polypropylène selon l'une quelconque des revendications 1 à 4, dans lequel la différence (V_{DC120°C}-V_{AC120°C}) entre la résistance au claquage diélectrique à une tension continue à 120 °C (V_{DC120°C}) et la résistance au claquage diélectrique à une tension alternative à 120°C (V_{AC120°C}) est de 280 V/µm ou plus et 300 V/µm ou moins.

6. Film de polypropylène selon l'une quelconque des revendications 1 à 5, dans lequel le Mz est supérieur à 700 000.

7. Film de polypropylène selon l'une quelconque des revendications 1 à 6, dans lequel :
- la distribution de poids moléculaires (Mw/Mn) est de 5,0 ou plus et 6,6 ou moins ;
- le Mz est de 720 000 ou plus et 790 000 ou moins ; et
- la fraction pondérale w est de 3,5 % ou plus et 3,7 % ou moins.

8. Film de polypropylène selon l'une quelconque des revendications 1 à 7, dans lequel la résine de polypropylène comprend des résines de polypropylène A et B, et la teneur en la résine de polypropylène A dans la résine de polypropylène est supérieure à la teneur en la résine de polypropylène B dans la résine de polypropylène ;
- la résine de polypropylène A a un Mw de 275 000 ou plus et moins de 350 000 ;
- la résine de polypropylène A a une distribution de poids moléculaires (Mw/Mn) de 5,8 ou plus et 10,0 ou moins ; et
- la résine de polypropylène A a un indice de fluidité (MFR_{A}) de 4,8 g/10 min ou plus et 5,5 g/10 min ou moins.

9. Film de polypropylène selon l'une quelconque des revendications 1 à 8, dans lequel la résine de polypropylène comprend des résines de polypropylène A et B, et la teneur en la résine de polypropylène A dans la résine de polypropylène est supérieure à la teneur en la résine de polypropylène B dans la résine de polypropylène ;
- la résine de polypropylène B a un Mw de 385 000 ou plus et 550 000 ou moins ;
- la résine de polypropylène B a une distribution de poids moléculaires (Mw/Mn) de 8,4 ou plus et 11,0 ou moins ; et
- la résine de polypropylène B a un indice de fluidité (MFR_{B}) de 0,1 g/10 min ou plus et 2,2 g/10 min ou moins.

10. Film de polypropylène selon la revendication 8 ou 9, dans lequel le rapport de la masse de la résine de polypropylène A sur la masse totale des résines de polypropylène A et B est de 65 à 75 % en masse.

11. Film de polypropylène selon l'une quelconque des revendications 1 à 10, dans lequel le film de polypropylène a une épaisseur de 1,0 µm ou plus et 6,0 µm ou moins.

12. Film de polypropylène intégré dans une couche métallique ayant le film de polypropylène selon l'une quelconque des revendications 1 à 11, et une couche métallique stratifiée sur un côté ou les deux du film de polypropylène.

13. Condensateur en film ayant le film de polypropylène intégré dans une couche métallique enroulé selon la revendication 12, ou ayant une structure dans laquelle une pluralité des films de polypropylène intégrés dans une couche métallique selon la revendication 12 sont stratifiés.
